# EUROPEAN PATENT APPLICATION

(11) **EP 1 703 648 A1**
(43) Date of publication of application: **20.09.2006**
(21) Application number: 04701113.5
(22) Date of filing: 09.01.2004
(51) Int. Cl.: H04B 7/26, H04B 1/16, H04B 1/40

(54) **RECEIVER AND TRANSMITTER/RECEIVER**

(71) Applicant: MITSUBISHI DENKI KABUSHIKI KAISHA, Chiyoda-ku, Tokyo 100-8310 (JP)
(72) Inventor: YOSHIDA, Yoshikazu, Chiyoda-ku Tokyo 100-8310 (JP)
(74) Representative: Sajda, Wolf E.
(86) International application number: PCT/JP2004/000115
(87) International publication number: WO 2005/067174

(57) **Abstract**

An object of the present invention is to achieve a receiver and a transmitter-receiver, such as a mobile telephone unit and a transceiver, that are capable of controlling a supplied power to the receiving unit including a variable gain amplifier with high precision. To accomplish the foregoing object, a receiver employs a configuration including, for example, a receiving unit (3), a gain control signal-generating unit (21) that designates a gain value of variable gain amplifiers (4a, 8a) in the receiving unit (3), a control unit (12), and a memory (13). The memory stores supplied power values to the receiving unit that are associated with gain values, and the control unit controls an electric power to be supplied to the receiving unit by referencing the supplied power values stored in the memory based on a gain value designated by a gain control signal (S5).

## Description

### TECHNICAL FIELD

The present invention relates to receivers and transmitter-receivers such as mobile telephone units and transceivers, and more particularly to a receiver and a transmitter-receiver that are effective in reducing power consumption.

### BACKGROUND ART

Receivers and transmitter-receivers such as mobile telephones have a receiving unit for high-frequency radio signal. Generally, a large electric power supplied to the receiving unit enables the receiving unit to operate at the optimum operating point, improving reception wave's NF (Noise Figure) performance (the ratio between the S/N ratio of input signal and the S/N ratio of output signal) and distortion performance (the ratio between the signal voltage-to-distortion voltage ratio of input signal and the signal voltage-to-distortion voltage ratio of output signal) as well as reception gains, and thus the reception performance improves. On the other hand, if the power supplied to the receiving unit is small, power consumption reduces, although the operation deviates from the optimum operating point, degrading the reception performance. Therefore, the power supplied to the receiving unit needs to be controlled according to the reception condition of the high-frequency radio signal. Specifically, when the reception condition of the high-frequency radio signal is good, reduction in power consumption should be pursued even if it involves the degradation in reception performance; on the other hand, if the reception condition of the high-frequency radio signal is poor, the supplied power to the receiving unit should be increased to pursue improvements in the reception performance.

For example, Patent Document 1 listed below shows a technique in which a supplied power to a receiving unit is controlled according to a result of detection of RSSI (Receive Signal Strength Indicator) signal, which indicates the reception condition.

In the case of controlling the supplied power to the receiving unit according to the result of detection of the RSSI signal, it is necessary to provide, as a RSSI signal detection circuit, a log-amp (Logarithmic Amplifier) circuit for logarithmically transforming an analog voltage signal that is an output from a demodulator in the receiving unit to generate RSSI signal, and an A/D converter for A/D (Analog → Digital) converting the output signal from the log-amp circuit, leading to an increase in the circuit scale.

In addition to Patent Document 1, Patent Documents 2 through 4 listed below disclose techniques related to the present application.
Patent Document 1
   Japanese Patent Application Laid-Open No. 5-37408 (1993)
Patent Document 2
   Japanese Patent Application Laid-Open No. 7-30957 (1995)
Patent Document 3
   Published Japanese Translation of PCT Application No. 2002-522938
Patent Document 4
   Japanese Patent Application Laid-Open No. 2002-217774

### SUMMARY OF THE INVENTION

It is an object of the present invention to resolve the foregoing problems and to achieve a receiver and a transmitter-receiver that are capable of controlling a supplied power to the receiving unit with high precision even without using a signal that indicates reception conditions, such as RSSI signal.

The receiver according to the present invention includes: a receiving unit (3) containing variable gain amplifiers (4a, 8a) capable of amplifying a reception wave with variable gain values, without degrading NF (Noise Figure) performance and distortion performance under a certain supplied power; a gain control signal-generating unit (21) for generating a gain control signal (S5) for designating the gain values in the variable gain amplifiers according to a received power of the reception wave; a control unit (12); and a memory (13), wherein the memory stores supplied power values to the receiving unit that are associated with the gain values; and the control unit controls the power to be supplied to the receiving unit by referencing the supplied power values stored in the memory based on the gain values designated by the gain control signal.

In the receiver according to the present invention, the control unit controls the power to be supplied to the receiving unit by referencing the supplied power values stored in the memory based on the gain values designated by the gain control signal. Consequently, the power supplied to the receiving unit can be controlled with high precision even without using a signal that indicates reception conditions, such as an RSSI signal, by utilizing a gain control signal that designates a gain value based on the reception condition of the reception wave.

A transmitter-receiver according to the present invention includes: a receiving unit (3) containing variable gain amplifiers (4a, 8a) capable of amplifying a reception wave with variable gain values, without degrading NF (Noise Figure) performance and distortion performance under a certain supplied power; a gain control signal-generating unit (21) for generating a gain control signal (S5) for designating the gain values in the variable gain amplifiers according to a received power of the reception wave; a transmitter unit (10) for generating a transmission wave; a transmission power detecting unit (11) for detecting the power of the transmission wave; a control unit (12); and a memory (13), wherein the memory stores supplied power values to the receiving unit that are associated with the gain values and the power of the transmission wave; and the control unit controls the power to be supplied to the receiving unit by referencing the supplied power values stored in the memory based on the gain values designated by the gain control signal and a detection result in the transmission power detecting unit.

In the transmitter-receiver according to the present invention, the control unit controls the power to be supplied to the receiving unit by referencing the supplied power values stored in the memory based on the gain values designated by the gain control signal and the detection result in the transmission power detecting unit. Consequently, the power supplied to the receiving unit can be controlled with high precision even without using a signal that indicates reception conditions, such as an RSSI signal, by utilizing a gain control signal that designates a gain value based on the reception condition of the reception wave, and further based on the signal intensity of the transmission wave.

These and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a diagram illustrating the configuration of a receiver according to a first preferred embodiment of the present invention.
Fig. 2 is a flowchart illustrating an control operation of the receiver according to the first preferred embodiment.
Fig. 3 is a graph illustrating the relationship of RSSI signal values and gain values and received field intensities.
Fig. 4 is a diagram illustrating a specific configuration example of the amplification stage of a variable gain amplifier in a low-noise amplifier and a demodulator of the receiver according to the first preferred embodiment.
Fig. 5 a diagram illustrating a specific configuration example of a receiving unit power control circuit in the receiver according to the first preferred embodiment.
Fig. 6 is a diagram illustrating the configuration of a receiver according to a second preferred embodiment of the present invention.
Fig. 7 is a flowchart illustrating an control operation of the receiver according to the second preferred embodiment.
Fig. 8 is a graph illustrating the relationship between gain values and supplied powers to the receiving unit in the receiver according to the second preferred embodiment.
Fig. 9 is a diagram illustrating the configuration of a transmitter-receiver according to a third preferred embodiment of the present invention.
Fig. 10 is a graph illustrating the relationship between gain values and transmission powers and supplied powers to the receiving unit in the transmitter-receiver according to the third preferred embodiment.

### BEST MODE FOR CARRYING OUT THE INVENTION

### First Preferred Embodiment

The present preferred embodiment is a receiver in which a supplied power to the receiving unit is controlled based on a gain value in a variable gain amplifier (VGA).

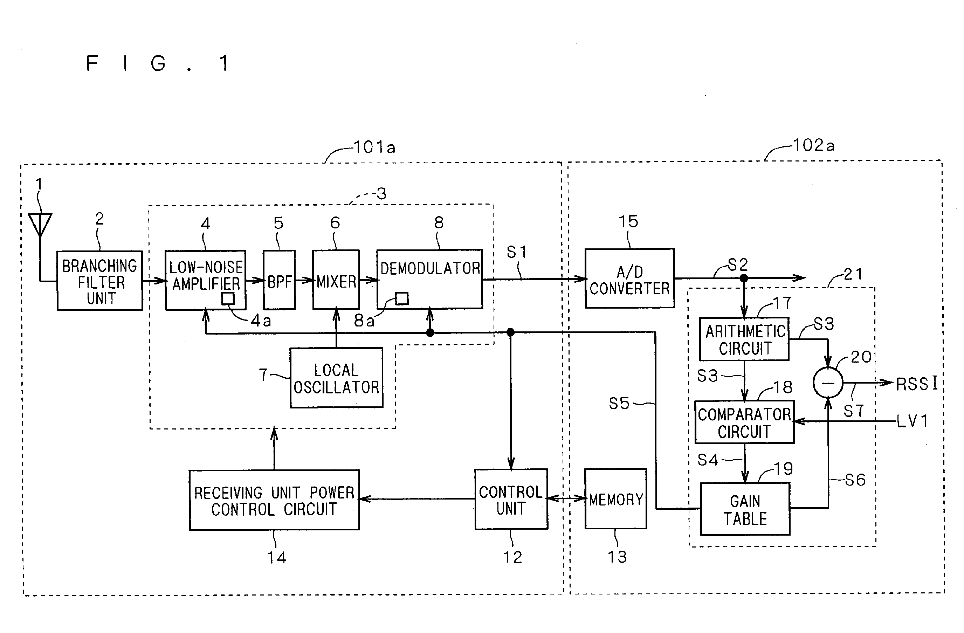

Fig. 1 shows the configuration of the receiver according to the present preferred embodiment. This receiver includes a radio unit 101a for performing a reception process of radio signal, and a baseband unit 102a for processing baseband signal that has been demodulated by the radio unit 101a. A reception wave from a base station (not shown) is received by an antenna 1 in the radio unit 101a, and is input to a receiving unit 3 in the radio unit 101a via a branching filter unit 2 in the radio unit 101a.

The receiving unit 3 is made up of a low-noise amplifier (LNA) 4, a BPF (Band Pass Filter) 5, a mixer 6, a local oscillator 7, and a demodulator 8. The reception wave is amplified in the low-noise amplifier 4, and the amplified reception wave is filtered at the BPF 5 as a signal of a predetermined frequency band. The filtered reception wave is frequency-converted at the mixer 6, which receives a signal with a predetermined frequency from the local oscillator 7. Then, the frequency-converted reception wave is demodulated at the demodulator 8 into a baseband signal S 1.

In addition, in the low-noise amplifier 4 and the demodulator 8, variable gain amplifiers 4a and 8a are provided that can amplify reception wave with a variable gain value without degrading the NF (Noise Figure) performance (the ratio between the S/N ratio of an input signal and the S/N ratio of an output signal) and the distortion performance (the ratio between the signal voltage-to-distortion voltage ratio of an input signal and the signal voltage-to-distortion voltage ratio of an output signal) under a certain supplied power.

Further provided in the radio unit 101a are a control unit 12 made up of a logic circuit in which several tens to several hundreds of logic gates are combined, and a receiving unit power control circuit 14 for controlling the power to be supplied to the receiving unit 3 based on the instruction from the control unit 12.

The baseband unit 102a is provided therein with an A/D converter 15 for A/D (analog to digital) converting a baseband signal S1 from the demodulator 8 and outputting the resultant signal as a digital signal S2, a gain control signal-generating unit 21 for generating a gain control signal S5 that controls a gain value in the variable gain amplifiers 4a and 8a in response to the received power of the reception wave, and a memory 13 constituted by, for example, a SRAM (Static Random Access Memory) connected to the control unit 12.

The gain control signal-generating unit 21 is furnished with an arithmetic circuit 17, a comparator circuit 18, a gain table 19, and a subtracter 20. The arithmetic circuit 17 is a circuit that is constituted by, for example, a DSP (digital signal processor) and is capable of arithmetic processing, and it calculates a voltage amplitude level of the baseband signal S1 from the digital signal S2 and calculates, from the the voltage amplitude level value, the received power that has passed through the radio unit 101a. The comparator circuit 18 is a digital comparator, and it compares a signal S3, which is the calculation result of the received power by the arithmetic circuit 17, with a demodulated signal reference level signal LV1, and outputs the difference as a signal S4. The gain table 19 is a circuit constituted by a memory, an adder, and a subtracter, and it calculates a gain value, which is to be output as a gain control signal S5, using the signal S4 and various parameters stored in the memory. The gain table 19 also calculates the total gain from the antenna 1 to the receiving unit 3 using various parameters stored in the memory, and outputs the result as a signal S6. The subtracter 20 subtracts the value of the signal S6 from the value of the signal S3, and outputs the result of the calculation as an RSSI signal S7.

Hereinbelow, generation of the gain control signal S5 will be described using specific numerical values as examples. For example, the total power loss at the antenna 1 and the branching filter unit 2 is assumed to be 2 dB. The present total gain value at the receiving unit 3 is assumed to be set at 20 dB.

The arithmetic circuit 17 calculates a voltage amplitude level of the baseband signal S 1 by putting the digital signal S2 that is output from the A/D converter 15 into a predetermined arithmetic expression, and calculates the received power that has passed through the radio unit 101a from the voltage amplitude level value. Herein, the value of the received power that has passed through the radio unit 101a is assumed to be, for example, -52 dB.

The comparator circuit 18 compares the signal S3, which indicates that the result of calculation is -52 dB, and a value of the demodulated signal reference level (the received power value that is most suitable for performing demodulation) signal LV1. Assuming that the value of the demodulated signal reference level signal LV1 is set at -40 dB, the comparator circuit 18 calculates the difference between -52 dB and -40 dB, and outputs the information indicating 12 dB, which is the difference, as the signal S4. It should be noted that, in this example with the illustrative numerical values, the present received power -52 dB falls short of the demodulated signal reference level -40 dB, and it is in an insufficient amplification condition.

The setting information indicating that the total gain value in the receiving unit 3 is 20 dB and the information indicating that the total power loss is in the antenna 1 and the branching filter unit 2 is 2 dB are stored in the memory in the gain table 19. Then, the adder in the gain table 19 adds the difference 12 dB, calculated by the comparator circuit 18, to the present total gain value 20 dB in the receiving unit 3.

Using the result of the addition, the gain table 19 outputs, as the gain control signal S5, information indicating a gain value of 32 dB, elevated 12 dB from the present total gain value 20 dB in the receiving unit 3, to the receiving unit 3. In addition, the subtracter in the gain table 19 outputs, as the signal S6, information indicating a value of 18 dB obtained by subtracting the total power loss 2 dB in the antenna 1 and branching filter unit 2 from the present total gain value 20 dB in the receiving unit 3 (which indicates the total gain value in the antenna 1, the branching filter unit 2, and the receiving unit 3) to the subtracter 20.

The subtracter 20 subtracts a value 18 dB, which is the content of the signal S6 from a value -52 dB, which is the content of the signal S3, and thus determines by the calculation that the received power of the reception wave that the antenna 1 is currently receiving is -70 dB. The result of the calculation becomes the RSSI signal S7.

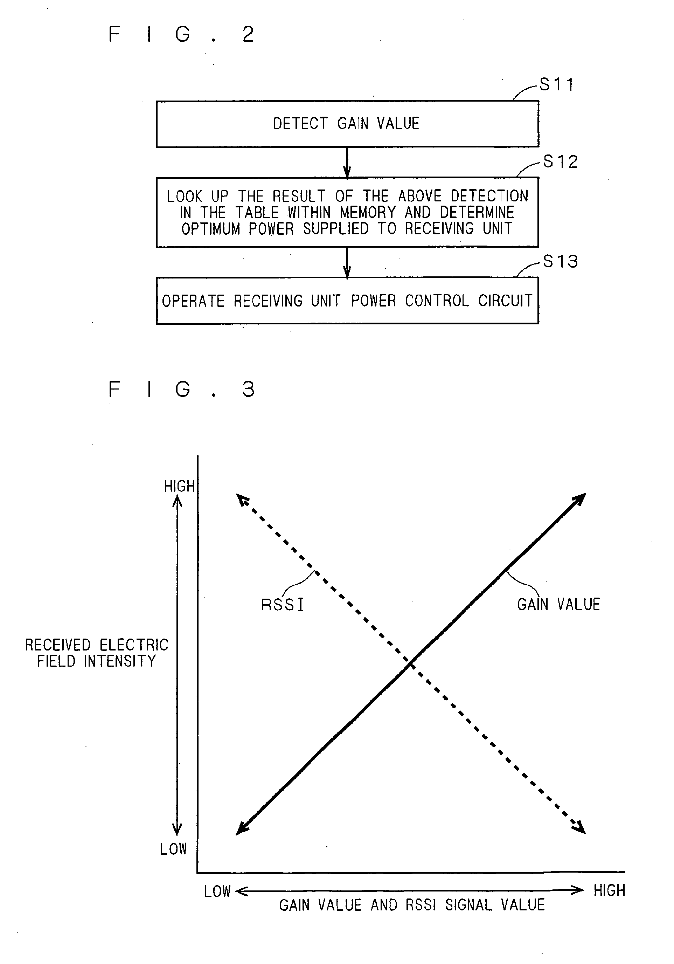

Next, the operation of the receiver according to the present preferred embodiment will be described. Fig. 2 is a flowchart illustrating a control operation of the receiver according to the present preferred embodiment.

First, the gain control signal S5 is input into the control unit 12, and the information of the gain value designated by the gain control signal S5 is detected in the control unit 12 (step S 11).

In the memory 13, values of power to be supplied to the receiving unit 3, which are associated with the gain values designated by the gain control signal S5, are stored in advance. Specifically, for example, if the gain value designated by the gain control signal S5 is within the range of from 0 dB to 10 dB, power a is adopted; if the gain value is within the range of from 11 dB to 20 dB, power b is adopted; if the gain value is within the range of from 21 dB to 30 dB, power c is adopted; if the gain value is within the range of from 31 dB to 40 dB, power d is adopted; if the gain value is within the range of from 41 dB to 50 dB, power e is adopted (a < b < c < d < e). In other words, power supplied to the receiving unit 3 is segmented into 5 steps of powers a to e so that one of the powers a to e is specified in association with a gain value designated by the gain control signal S5.

In this case, the supplied power is specified so that as the gain value designated by the gain control signal S5 becomes lower, the power supplied to the receiving unit 3 reduces. The reason is as follows; when the gain value designated by the gain control signal S5 is low, the reception wave is sent with a sufficient power and it is considered unnecessary to increase the gain greatly; therefore, reduction in power consumption is pursued by reducing the supplied power to the receiving unit 3.

Conversely, as the gain value designated by the gain control signal S5 becomes higher, the supplied power is specified so that the supplied power to the receiving unit 3 increases. The reason is as follows; when the gain value designated by the gain control signal S5 is high, the reception condition is considered poor; therefore, the supplied power to the receiving unit 3 is increased to operate the receiving unit 3 at the optimum operating point so that the reception performance can be improved.

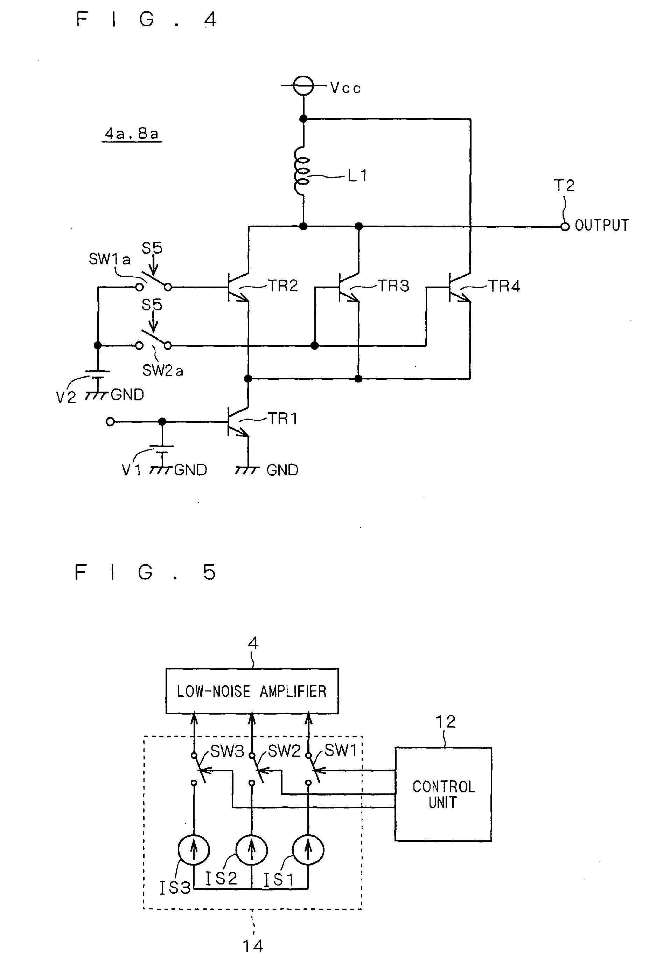

Fig. 3 is a graph illustrating the relationship between gain values designated by the gain control signal S5 and received field intensities. As is seen from Fig. 3, as the received field intensity decreases, the gain value is set to be higher, while as the received field intensity increases, the gain value is set to be lower.

Fig. 3 additionally shows the relationship between RSSI signal values and received field intensities; the RSSI signal value becomes a smaller value as the received field intensity reduces, while it becomes a larger value as the received field intensity increases.

It should be noted that although in the foregoing description, the power to be supplied to the receiving unit 3 is specified so that it change from a, then to b, then to c, then to d, and then to e, in a stepwise manner, the power to the receiving unit 3 may be specified so as to change continuously according to the gain value, not in a stepwise manner.

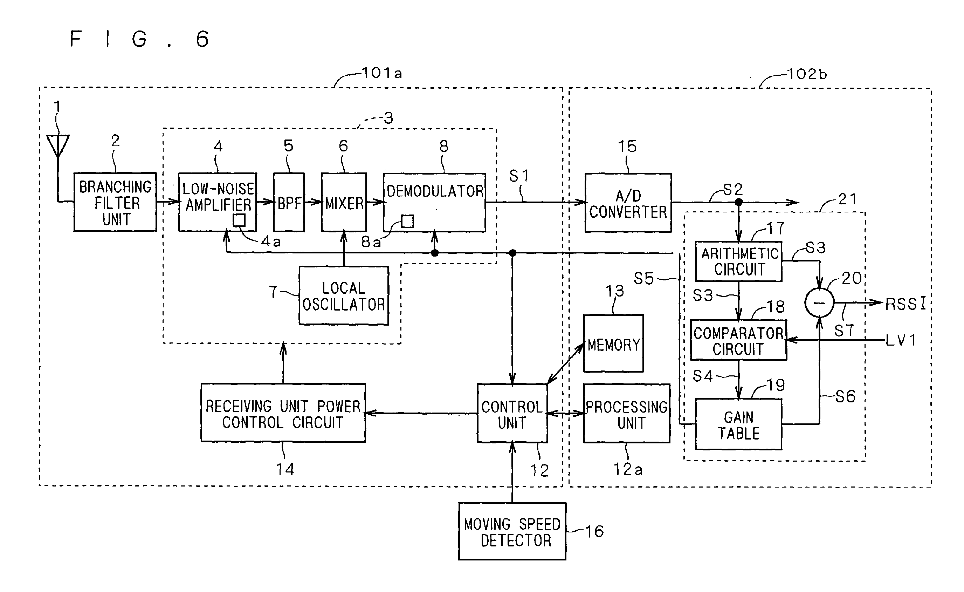

Fig. 4 is a diagram illustrating a specific configuration example of a portion of the amplification stage of the variable gain amplifiers 4a and 8a respectively provided in the low-noise amplifier 4 and the demodulator 8. Each of the variable gain amplifier 4a and the variable gain amplifier 8a has a configuration in which a plurality of amplification stages shown in Fig. 4 are connected in series.

The amplification stage of Fig. 4 is provided therein with a transistor TR1 having an emitter to which a ground potential GND is fed, a base connected to an input terminal T1, and a collector. A direct current power supply V1 is connected to the base of the transistor TR1, to which a direct current bias potential higher than the ground potential GND is fed.

In addition, respective emitters of transistors TR2 to TR4 are commonly connected to the collector of the transistor TR1. The collectors of the transistors TR2 and TR3 are commonly connected to one end of an inductor L1 and an output terminal T2. A power supply potential Vcc is fed to the other end of the inductor L1. The power supply potential Vcc is also fed to the collector of the transistor TR4. It should be noted that another inductor (not shown: the supplied power from the receiving unit power control circuit 14 of Fig. 1 causes current to flow through the other inductor) is disposed adjacently to the inductor L1, and the inductor L1 is supplied with the power from the other inductor because the current is induced in the inductor L1 by the current flowing through the other inductor.

A direct current power supply V2 is connected to the base of the the transistor TR2 via a switch SW1a and the direct current power supply V2 is also connected to the base of the transistor TR3 via a switch SW2a, and a direct current bias potential higher than the ground potential GND can be applied to the base of the transistors TR2 and TR3. The switching on and off of the switches SW1a and SW2a is controlled according to the gain value designated by the gain control signal S5. The base of the transistor TR4 is also connected to the base of the transistor TR3.

Basically, when the power given to an amplifier (for example, electric current) is varied, the gain of the amplifier changes, and at the same time, NF performance and the distortion performance of the amplifier also change. The variable gain amplifier is an amplifier that can amplify an input signal with a variable gain value without degrading the NF performance and the distortion performance under a certain supplied power

Here, the size ratio of the transistors TR1 to TR4 is assumed to be TR1:TR2:TR3:TR4 = 5:5:1:4, for example.

When the switch SW1a is on and the switch SW2a is off, a current flows through the transistors TR2 and TR1. Also, when the switch SW1a is off and the switch SW2a is on, a current flows through the transistors TR3, TR4, and TR1. Since the size ratio of the transistor TR2 (5) is the same value as the total of the size ratios of the transistors TR3 and TR4 (1 + 4 = 5), the current flowing through the amplification stage of Fig. 4 as a whole does not change in either case. This means that, in either case, the power consumption results in the same value and the NF performance and the distortion performance are the same also.

On the other hand, when the switch SW1a is on and the switch SW2a is off, the current at the collector of the transistor TR2 flows through the output terminal T2, while when the switch SW1a is off and the switch SW2a is on, the current at the collector of the transistor TR3 flows through the output terminal T2. Since the size ratio of the transistors TR2 and TR3 is TR2:TR3 = 5:1, the gain ratio of the two cases results in 5:1.

In this way, the amplification stage of Fig. 4 can amplify an input signal with a variable gain value according to the combinations of on and off of the switches SW1a and SW2a, without degrading the NF performance and the distortion performance. Because the variable gain amplifier 4a and the variable gain amplifier 8a has a plurality of such amplification stages connected in series, the gain value of the variable gain amplifier 4a and the variable gain amplifier 8a as a whole can be arbitrarily set according to combinations of on and off of the switches SW1a and SW2a in each amplification stage. The gain control signal S5 has a function to instruct the switches SW1a and SW2a in each amplification stage to be turned on and off.

The control unit 12 determines the power to be supplied to the receiving unit power control circuit 14 by referencing the supplied power values stored in the memory 13 based on the gain value designated by the gain control signal S5 (step S12). Specifically, based on the information of the gain value designated by the gain control signal S5, the control unit 12 decides to which of the foregoing 5 steps of powers a to e a supplied power corresponding to that gain value falls into, by referencing the stored contents of the memory 13. Then, the information indicating the determined power value is transferred from the control unit 12 to the receiving unit power control circuit 14 (step S13).

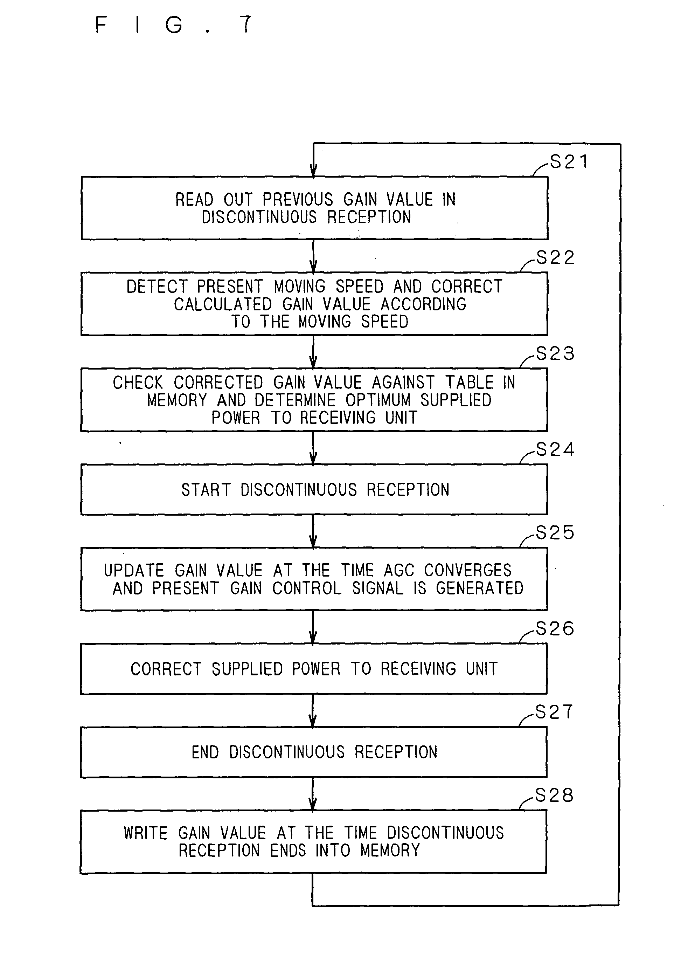

Fig. 5 is a diagram illustrating one example of the specific configuration of the receiving unit power control circuit 14. The receiving unit power control circuit 14 is furnished with current sources IS1 to IS3 and switches SW1 to SW3, and it adjusts a supplied power to the low-noise amplifier 4 and to the other circuits in the receiving unit 3 according to instruction from the control unit 12.

Specifically, the switches SW1 to SW3 are respectively connected to the current sources IS1 to IS3 so that currents generated in the current sources IS1 to IS3 can flow into the low-noise amplifier 4 and into the other circuits in the receiving unit 3 via the switches SW1 to SW3, respectively. The control unit 12 controls the amount of current that flows into the low-noise amplifier 4 and into the other circuits in the receiving unit 3 by turning on any one of, or two or more of, the switches SW1 to SW3. It should be noted that the values of the currents generated by the current sources IS 1 to IS3 may be the same or different.

In the receiver according to the present preferred embodiment, the control unit 12 controls the power to be supplied to the receiving unit 3 by referencing the supplied power values stored in the memory 13 based on the gain value designated by the gain control signal S5. Therefore, even without a signal that indicates reception conditions, such as RSSI signal, the supplied power to the receiving unit 3 can be controlled with high precision by utilizing the gain control signal S5 that designates a gain value based on the reception condition of the reception wave.

In a receiver, it is common to generate a signal for designating a gain value in the receiving unit, such as the above-described gain control signal S5. In the case of the present preferred embodiment, it is possible to control the supplied power to the receiving unit 3 merely by supplying such an existing signal to the control unit 12, and it is unnecessary to newly provide a control signal.

It should be noted that although the RSSI signal S7 is generated by the subtracter 20 in the foregoing description, it is possible to eliminate the subtracter 20 since the calculation of the RSSI signal S7 is not particularly necessary in the control of the receiving unit power control circuit 14 of the present preferred embodiment.

### Second Preferred Embodiment

The present preferred embodiment is a modified example of the receiver according to the first preferred embodiment, and is a receiver that is capable of discontinuous reception and controls the power to be supplied to the receiving unit based on a gain value designated by a gain control signal S5 during past discontinuous reception.

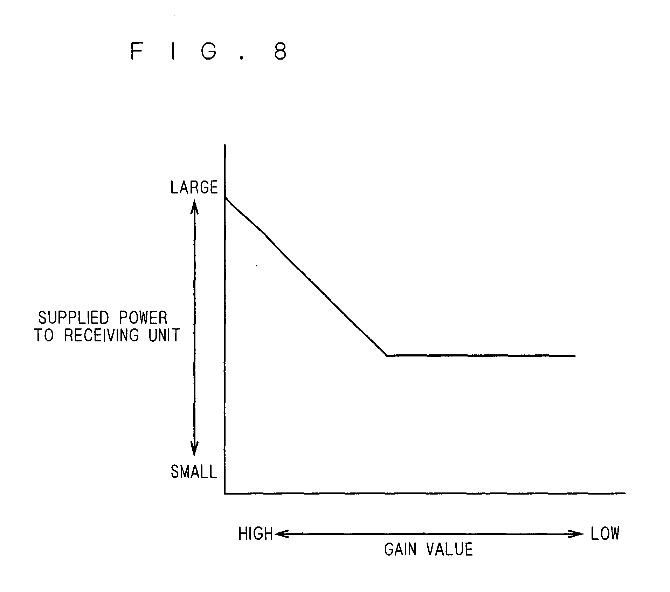

Fig. 6 shows the configuration of a receiver according to the present preferred embodiment. In this receiver, the configurations of the antenna 1, the branching filter unit 2, the receiving unit 3, the control unit 12, the memory 13, the receiving unit power control circuit 14, the A/D converter 15, and the gain control signal-generating unit 21 are the same as those of the receiver according to the first preferred embodiment. It should be noted that the receiving unit 3 is capable of performing discontinuous reception.

The receiver according to the present preferred embodiment is further provided with a processing unit 12a that is constituted by a DSP or the like, and a moving speed detector 16 that is capable of detecting the moving speed of the receiver. It should be noted that, for the moving speed detector 16, it is possible to adopt, for example, a device described in Japanese Patent Application Laid-Open No. 11-252633 (1999).

In the case of mobile telephone, for example, the gain control signal S5 is generated at all times during continuous reception, such as during voice communication, and therefore, it is possible to optimally control a supplied power to the receiving unit based on the latest gain value. However, during discontinuous reception, such as during a stand-by state, it is difficult to precisely set a gain value from the initial stage in one single discontinuous reception, and it is not always possible to control the supplied power to the receiving unit 3 with high precision.

In view of this, in the present preferred embodiment, the control unit 12 controls the supplied power to the receiving unit 3 based on the gain values in previous several discontinuous reception events. Accordingly, the control unit 12 writes data of a gain value into the memory 13 each time discontinuous reception takes place. Thus, the memory 13 is allowed to accumulate data of gain values for previous several times of discontinuous reception.

After one discontinuous reception, the control unit 12 reads out the data of the previous stored gain values from the memory 13 prior to performing the next discontinuous reception, and makes the processing unit 12a calculate the average value of them. Then, based on the result of the calculation, it controls the receiving unit power control circuit 14.

It should be noted that, in the present preferred embodiment, the processing unit 12a performs weighting so that, among the data of a plurality of gain values, more recent data have a greater rate of contribution in calculating the average value of gain values, in order to consider most recent communication conditions more important. Specifically, when the average value of the gain values for the previous four times needs to be calculated, for example, the weighting is performed in such a manner that: the rate of contribution of the most recent data is 100%; the rate of contribution of the data previous to that data is 50%; the rate of contribution of the data still previous thereto is 30%; and the rate of contribution of the data further previous thereto is 20%.

For example, in the case that the gain values for the previous four times are 30 dB, 40 dB, 30 dB, and 20 dB, the average value is (30 dB + 40 dB + 30 dB + 20 dB)/4 = 30 dB if simply calculated, but it becomes (30 dB × 1 + 40 dB × 0.5 + 30 dB × 0.3 + 20 dB × 0.2)/(1 + 0.5 + 0.3 + 0.2) = 31.5 dB, if the above-described weighting is performed.

In the present preferred embodiment, the processing unit 12a corrects the average value of gain values taking the present moving speed of the receiver into consideration, in order to increase the accuracy in calculation of the gain values during discontinuous reception. The data of the moving speed of the receiver detected by the moving speed detector 16 is sent to the processing unit 12a by the control unit 12.

Generally, the greater the moving speed, the poorer the quality of telecommunication; therefore, the processing unit 12a corrects the average value so that as the moving speed value is greater, the gain value is also greater. Specifically, for example, the correction is made in such a manner that: the calculated average value of gain values is made 1.2 times when the moving speed is 0 km/h to 8 km/h; the calculated average value is made 1.5 times when the moving speed is 8 km/h to 16 km/h; the calculated average value is made 1.8 times when the moving speed is 16 km/h to 24 km/h; and the calculated average value is made 2 times when the moving speed is greater than 24 km/h.

Taking the foregoing average value 31.5 dB after the weighting as an example, the result is: 31.5 dB × 1.8 = 56.7 dB when the present moving speed is 20 km/h.

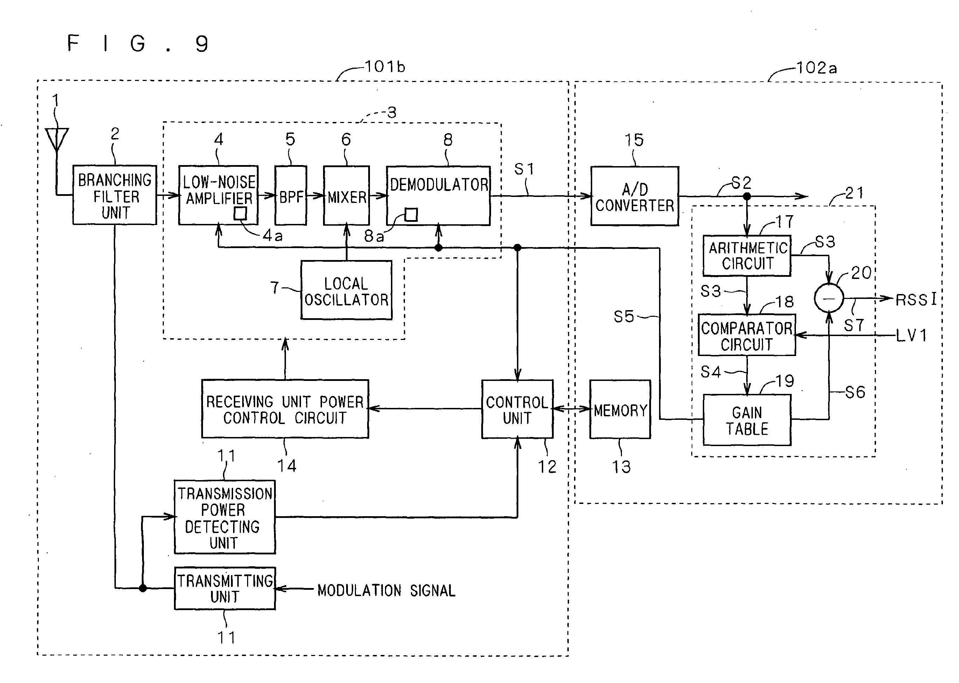

Fig. 7 is a flowchart illustrating a control operation of the receiver according to the present preferred embodiment.

First, the control unit 12 reads out data of stored previous gain values from the memory 13 (step S21). Then, the processing unit 12a is made to calculate the average value of them while performing the above-described weighting.

Furthermore, the control unit 12 makes the moving speed detector 16 detect the present moving speed of the receiver, and sends the information to the processing unit 12a. The processing unit 12a corrects the calculated average value in the foregoing manner (step S22).

In the memory 13, values of the power to be supplied to the receiving unit 3 are stored in advance in association with gain values. In the first preferred embodiment, the power supplied to the receiving unit 3 is specified so as to change from a, then to b, then to c, then to d, and then to e, in a stepwise manner, the power to the receiving unit 3 may be specified so as to change continuously according to the gain value, not in a stepwise manner.

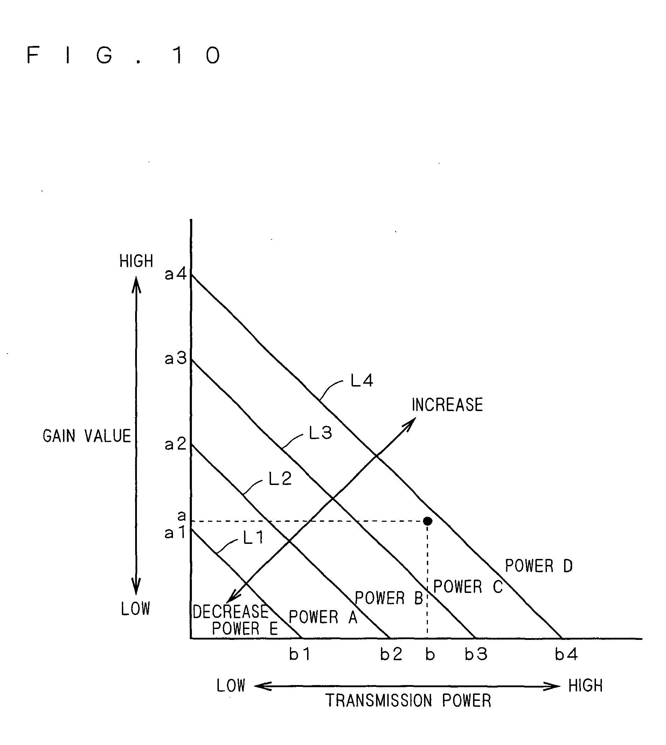

Specifically, for example, as illustrated in the graph of Fig. 8, in which supplied powers to the receiving unit and gain values are respectively represented on the vertical axis and the horizontal axis, the supplied power to the receiving unit may preferably be specified so that if the gain value is less than a predetermined value, the supplied power to the receiving unit is set at a constant value, while if the gain value is equal to or greater than a predetermined value, the supplied power to the receiving unit is increased linearly as the gain value increases.

Then, the control unit 12 determines the power to be supplied to the receiving unit power control circuit 14 by referencing the supplied power values stored in the memory 13 based on the average value of gain values that has been corrected by the processing unit 12a (step S23). Thereafter, discontinuous reception is started, and the information of the determined power value is transferred from the control unit 12 to the receiving unit power control circuit 14 (step S24).

During discontinuous reception, an AGC (automatic gain control) process is carried out in the receiving unit 3. Once output voltage converges by the AGC process and a present gain control signal S5 is generated, the control unit 12 updates the gain value from the previous average value at that point of time (step S25). Then, the control unit 12 again determines a power value to be supplied by referencing the supplied power values stored in the memory 13, and transfers the resultant value to the receiving unit power control circuit 14. The receiving unit power control circuit 14 corrects the power value supplied to the receiving unit 3 based on that information (step S26).

In the initial stage of discontinuous reception, the AGC process has not yet completed, so the supplied power to the receiving unit should be determined based on the gain values of previous several times; however, in the case that the information of the latest gain value can be obtained during discontinuous reception, it is desirable to control the supplied power to the receiving unit again based on that information.

Then, the receiving unit 3 finishes the discontinuous reception (step S27), and the control unit 12 writes the information of the gain value at the time the discontinuous reception is completed into the memory 13 (step S28).

Thereafter, the process returns to step S21, the control unit 12 again determines the power value to be supplied to the receiving unit 3 using the information of the previous gain values during discontinuous reception.

In the receiver according to the present preferred embodiment, the processing unit 12a calculates the average value of gain values using the gain values during discontinuous reception that have been written into the memory 13, and the control unit 12 controls the power to be supplied to the receiving unit 3 by referencing the supplied power values stored in the memory 13 based on the average value of gain values that has been calculated by the processing unit 12a. Therefore, it becomes possible to control the power to be supplied to the receiving unit 3 based on the most recent gain value from the initial stage of one single discontinuous reception. This makes it possible to control the supplied power to the receiving unit 3 with high precision. This is effective particularly in a system in which the gain control signal S5 cannot be generated until the AGC process finishes, such as W-CDMA.

Moreover, the processing unit 12a performs weighting in such a manner that more recent data among the data of a plurality of gain values have a greater contribution to calculate the average value. Therefore, it becomes possible to carry out a correction calculation in which the nearest previous communication condition is reflected more, making it possible to control the supplied power to the receiving unit 3 more precisely.

Furthermore, the processing unit 12a performs a correction such that as the moving speed value is greater, the average value becomes smaller. Therefore, the moving state of the receiver can be reflected on the gain value, and the supplied power to the receiving unit can be controlled with even more precisely.

In the case that the gain control signal-generating unit 21 generates the latest gain control signal S5 during discontinuous reception, the control unit 12 again controls the power to be supplied to the receiving unit 3 based on the gain value designated by the latest gain control signal S5. Therefore, the supplied power to the receiving unit can be controlled according to the latest telecommunication condition.

### Third Preferred Embodiment

The present preferred embodiment is also a modified example of the receiver according to the first preferred embodiment, and is a transmitter-receiver that also has a transmission function and controls the supplied power to the receiving unit based not only on the gain value designated by the gain control signal S5 but also on transmission power of a transmission wave.

Fig. 9 illustrates the configuration of a transmitter-receiver according to the present preferred embodiment. In this transmitter-receiver, the configurations of the antenna 1, the branching filter unit 2, the receiving unit 3, the control unit 12, the memory 13, the receiving unit power control circuit 14, the A/D converter 15, and the gain control signal-generating unit 21 are the same as those of the receiver according to the first

### preferred embodiment.

The transmitter-receiver according to the present preferred embodiment further includes a transmitter unit 10 that generates a modulation signal from a signal generation unit (now shown) as a transmission wave and sends it out to the branching filter unit 2, and a transmission power detecting unit 11 that detects the power of the transmission wave generated by the transmitter unit 10.

Next, the operation of the transmitter-receiver according to the present preferred embodiment is described.

First, the gain control signal S5 is generated in the gain control signal-generating unit 21, as in the case of the first preferred embodiment. In addition, the power of the transmission wave is detected in the transmission power detecting unit 11. For the transmission power detecting unit 11, a measurement device may be adopted that measures electric power utilizing, for example, a thermocouple or a Hall element. The information of the gain value designated by the gain control signal S5 and the transmission wave power is input to the control unit 12.

In the memory 13, power values to be supplied to the receiving unit 3 are stored in advance in association with gain values and transmission wave powers. Specifically, for example, in the graph of Fig. 10 in which gain values and transmission wave powers are respectively represented on the vertical axis and the horizontal axis, a power value to be supplied to the receiving unit 3 is specified for each region in the graph. Specifically, as illustrated in Fig. 3, the supplied power to the receiving unit 3 is segmented into five steps, power A to power E (E < A < B < C < D), one of the powers A to E is specified according to the values of the gain value and the transmission wave power.

More specifically, in Fig. 10, a power value A is adopted in the region between line L1 that connects a gain value a1 and a transmission wave power value b1 and line L2 that connects a, gain value a2 (> a1) and a transmission wave power value b2 (> b1). Likewise, a power value B is adopted in the region between line L2 and line L3 that connects a gain value a3 (> a2) and a transmission wave power value b3 (> b2); a power value C is adopted in the region between line L3 and line L4 that connects a gain value a4 (> a3) and a transmission wave power value b4 (> b3); a power value D is adopted in the region that is above and further rightward than line L4; and a power value E is adopted in the region below and further leftward than line L1, respectively.

In Fig. 10, the supplied power to the receiving unit 3 is specified so as to decrease as the gain value lowers, or as the transmission power value lowers. The reason is as follows. If the gain value is low, the reception wave is considered to have been sent with a sufficient power, or if the power of the transmission wave is low, the adverse effect on the reception wave is accordingly small; therefore, reduction in power consumption is pursued by reducing the supplied power to the receiving unit 3.

Conversely, the supplied power to the receiving unit 3 is specified so as to increase as the gain value becomes higher, or as the transmission power value becomes higher. The reason is as follows. If the gain value is high, the reception condition is considered poor, or if the power of the transmission wave is high, the adverse effect on the reception wave is great; therefore, the supplied power to the receiving unit 3 is increased to operate the receiving unit 3 at the optimum operating point, whereby improvements in the reception performance is pursued.

It should be noted that in Fig. 10, the power to be supplied to the receiving unit 3 is specified so as to change from E, then to A, then to B, then to C, and then to D, in a stepwise manner, but the power to the receiving unit 3 changes continuously according to the gain value and the transmission wave power, not in a stepwise manner.

Then, the control unit 12 determines the power to be supplied to the receiving unit power control circuit 14 by referencing the supplied power values stored in the memory 13 based on the gain value designated by the gain control signal S5 and the result of detection by the transmission power detecting unit 11. Specifically, the control unit 12 determines, based on the information of the gain values and the transmission wave powers stored in the memory 13, which of the regions in the graph of Fig. 10 a gain value and a transmission wave power value fall into. As illustrated in Fig. 10, for example, if the gain value is a and the power of the transmission wave is b, it is determined that the value of the power to be supplied to the receiving unit 3 is C. Then, the information of the determined power value is transferred from the control unit 12 to the receiving unit power control circuit 14.

In the transmitter-receiver according to the present preferred embodiment, the control unit 12 controls the power to be supplied to the receiving unit 3 by referencing the supplied power values stored in the memory 13 based on the gain value designated by the gain control signal S5 and the detection result by the transmission power detecting unit 11. Therefore, even without a signal that indicates reception conditions, such as RSSI signal, the supplied power to the receiving unit 3 can be controlled with high precision by utilizing a gain control signal that designates a gain value based on the reception condition of the reception wave, and further based on the signal intensity of the transmission wave.

While the invention has been shown and described in detail, the foregoing description is in all aspects illustrative and not restrictive. It is therefore understood that numerous other modifications and variations can be devised without departing from the scope of the invention.

### INDUSTRIAL APPLICABILITY

This invention is applicable to devices including a receiver and a transmitter-receiver, and may be applicable to, for example, telecommunication devices, such as mobile telephone units, transceivers, PDAs (Personal Digital Assistance), and notebook computers.

## Claims

1. A receiver comprising:
a receiving unit (3) containing variable gain amplifiers (4a, 8a) capable of amplifying a reception wave with variable gain values, without degrading NF (Noise Figure) performance and distortion performance under a certain supplied power;
a gain control signal-generating unit (21) for generating a gain control signal (S5) for designating said gain values in said variable gain amplifiers according to a received power of said reception wave;
a control unit (12); and
a memory (13),
wherein
said memory stores supplied power values to said receiving unit that are associated with said gain values; and
said control unit controls a power to be supplied to said receiving unit by referencing said supplied power values stored in said memory based on said gain values designated by said gain control signal.

2. The receiver according to claim 1, further comprising:
a processing unit (12a), and wherein:
said receiving unit is capable of discontinuous reception of said reception wave;
said gain values designated by said gain control signal are written into said memory each time said discontinuous reception takes place;
said processing unit calculates an average value of said gain values using said gain values that have been written into said memory during discontinuous reception; and
said control unit controls said power to be supplied to said receiving unit by referencing said supplied power values stored in said memory based on said average value of said gain values calculated by said processing unit.

3. The receiver according to claim 2, wherein said processing unit calculates said average value by performing weighting such that contribution of more recent data among a plurality of said gain values are greater.

4. The receiver according to claim 2, further comprising:
a moving speed detector (16) capable of detecting a moving speed of said receiver, and wherein
said processing unit performs correction so that when said moving speed value is greater, said average value becomes smaller.

5. The receiver according to claim 2, wherein, when said gain control signal-generating unit generates a latest one of said gain control signal during discontinuous reception, said control unit again controls a power to be supplied to said receiving unit by referencing said supplied power values stored in said memory based on a gain value designated by said latest one of said gain control signal.

6. A transmitter-receiver, comprising:
a receiving unit (3) containing variable gain amplifiers (4a, 8a) capable of amplifying a reception wave with variable gain values, without degrading NF (Noise Figure) performance and distortion performance under a certain supplied power;
a gain control signal-generating unit (21) for generating a gain control signal (S5) for designating said gain values in said variable gain amplifiers according to a received power of said reception wave;
a transmitter unit (10) for generating a transmission wave;
a transmission power detecting unit (11) for detecting a power of said transmission wave;
a control unit (12); and
a memory (13),
wherein
said memory stores supplied power values to said receiving unit that are associated with said gain values and said power of said transmission wave; and
said control unit controls a power to be supplied to said receiving unit by referencing said supplied power values stored in said memory based on said gain values designated by said gain control signal and a detection result in said transmission power detecting unit.
